# EUROPÄISCHE PATENTANMELDUNG

(11) **EP 1 168 463 A1**
(43) Veröffentlichungstag der Anmeldung: **02.01.2002**
(21) Anmeldenummer: 00113315.6
(22) Anmeldetag: 23.06.2000
(51) Int. Cl.: H01L 41/053, H01L 41/08

(54) **Faserverbundwerkstoff mit darin integriertem piezoelektrischem Sensor oder Aktor**

(71) Anmelder: DORNIER GmbH, 88039 Friedrichshafen (DE)
(72) Erfinder: Dürr, Johannes K., 88709 Meersburg (DE)
(74) Vertreter: Meel, Thomas

(57) **Zusammenfassung**

Die Erfindung betrifft einen Faserverbundwerkstoff (10) mit darin integriertem piezoelektrischem Aktor (A) oder Sensor. Gemäß der Erfindung sind die elektrischen Zuleitungen (11) für den Aktor (A) oder Sensor in Form elektrisch isolierter, dünner Drähte ausgebildet, die senkrecht zu den Laminatlagen aus dem Faserverbundwerkstoff (10) herausgeführt sind, wobei die Fasern durch das Herausführen der Zuleitungen (11) nicht durchtrennt, sondern auseinandergeschoben werden.

## Beschreibung

Die Erfindung betrifft einen Faserverbundwerkstoff mit darin integriertem piezoelektrischem Sensor oder Aktor.

Bei piezoelektrischen Werkstoffen, wie etwa Quarzkristallen oder PZT-Keramiken (PZT = Blei - Zirkonat - Titanat), führt ein angelegtes elektrisches Feld zu Dehnungen bzw. Kontraktionen des Materials. Piezokeramische Aktoren sind damit in der Lage, elektrische Energie direkt in mechanische Energie umzuwandeln und bieten Vorteile wie hohe Stellauflösung, hohe Stellkräfte und sehr kurze Ansprechzeiten bei kleinem Bauvolumen. Dieser Effekt ist bei piezoelektrischen Werkstoffen umkehrbar, d.h. im Falle einer auf eine solche Keramik ausgeübten zeitlich veränderlichen mechanischen Dehnung entsteht zwischen den Elektroden eine Ladungsverschiebung, die über diese wiederum als elektrisches Sensorsignal abgegriffen werden kann. In Kombination mit geeigneter Sensorik und Regelung lassen sich Stellsysteme realisieren, die sich selbsttätig , d.h. adaptiv an veränderte Betriebsbedingungen anpassen können.
Typische Bauweisen piezokeramischer Aktoren und Sensoren sind Stapelaktoren, Elongatoren und Biegeaktoren. Erstere bestehen aus Stapeln dünner piezokeramischer Scheiben, die sich unter einem äußeren elektrischen Feld entlang der Stapellängsachse annähernd linear ausdehnen oder verkürzen. Die beiden letzteren bestehen aus dünnen keramischen Platten, die in der Regel flächig mit einer Trägerstruktur verbunden werden und diese bei Vorgabe einer elektrischen Spannung dehnen bzw. bei Dehnung der Struktur ein elektrisches Signal erzeugen. Bei asymmetrischer Integration in die Trägerstruktur oder bei gegensinniger Ansteuerung eines Bimorphs (Bimorph = Aktor oder Sensor aus mindestens zwei separat kontaktierten und gegeneinander isolierten piezoelektrischen Wafern, die in zwei oder mehr Ebenen parallel und deckungsgleich übereinander angeordnet sind) können mit den Aktoren somit auch Biegemomente induziert werden. Bei blockierter Dehnung können Elongatoren und Biegeelemente unter elektrischer Ansteuerung Kräfte auf die entsprechende Struktur übertragen und somit in gewisser Weise deren Steifigkeit erhöhen.
Die induzierten Dehnungen und Krümmungen bzw. Kräfte und Momente piezokeramischer Elongatoren und Bieger lassen sich zur adaptiven Dämpfung von Strukturschwingungen und zur aktiven Formkontrolle, d.h. Anpassung der geometrischen Gestalt an die jeweiligen Betriebsbedingungen, nutzen. In Kombination mit Faserverbundwerkstoffen, die aufgrund ihrer gegenüber konventionellen metallischen Werkstoffen hervorragenden Eigenschaften zunehmend in hochbelasteten wie auch hochpräzisen Strukturen insbesondere in der Luft- und Raumfahrt zur Anwendung kommen, bietet sich die einmalige Möglichkeit, derartige Aktoren und Sensoren auf Basis piezokeramischer Werkstoffe direkt in die Struktur einzubetten, anstatt sie lediglich auf deren Oberfläche zu applizieren. Als Resultat erhält man adaptive Strukturen von hoher Festigkeit bei gleichzeitig geringem Gewicht, die in zukünftigen Systemen kostengünstig sowohl in der Fertigung wie auch im Dauereinsatz sein können.
Die wesentlichen Vorteile, die für eine Integration der Aktorik / Sensorik im Vergleich zu Applikation auf der Bauteiloberfläche sprechen, lassen sich wie folgt zusammenfassen:
• Höhere Effektivität der Dehnungsübertragung
• Integration unter höherer mechanischer (Druck-) Vorspannung möglich
• Schutz gegen Umwelt- und Medieneinflüsse
• Wahrung aerodynamischer Konturen / kein bzw. nur geringer Einfluß auf die Oberflächenqualität eines Bauteils
Mittlerweile ist eine Reihe wichtiger Anwendungsfelder für piezokeramische Aktoren und Sensoren zur Schwingungsunterdrückung, Schallminderung oder Formkontrolle adaptiver Strukturen identifiziert und teilweise bereits in Form von Demonstratoren wie auch Produkten realisiert worden. Diese umfassen moderne Raumfahrzeuge ebenso wie zivile und militärische Systeme, wie beispielsweise Trägerraketen, Satelliten, Hubschrauber, Flug-, Straßen- und Schienenfahrzeuge, aber auch Unterseeboote und Torpedos.

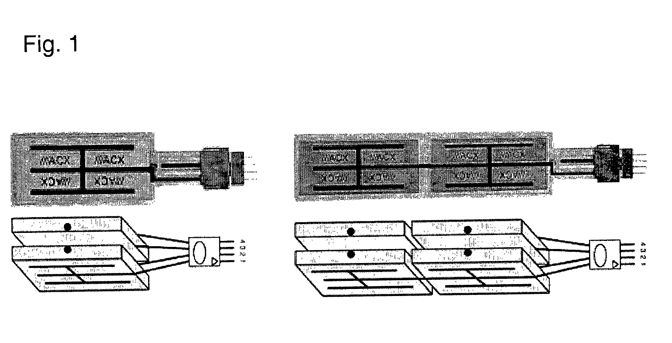

Die bei der Integration von Piezokeramikaktoren in einen Faserverbundwerkstoff auftretenden Probleme werden im folgenden beispielhaft an dem QuickPack® des amerikanischen Herstellers Active Control Experts (ACX) [ACX], Fig. 1) erläutert. Dies ist derzeit der einzige kommerziell verfügbare Piezokeramikaktor/-sensor, der aufgrund seiner in Modulform aufgebauten Konfiguration mit Zuleitungen, elektrisch isolierender Kapselung sowie mechanischer Stabilisierung der spröden Piezokeramik in industriellem Maßstab einsetzbar erscheint. ACX QuickPacks® sind flache, dünne piezokeramische Aktoren bzw. Sensoren, die in erster Näherungen dem angelegten elektrischen Feld proportionale Kräfte bzw. Dehnungen erzeugen, die primär in der Ebene des Aktors genutzt werden. Sie bestehen in der Regel aus einem (Unimorph) bzw. zwei übereinander angeordneten, gegeneinander isolierten und separat ansteuerbaren piezokeramischen Wafern (Bimorph), wobei letztere bei gegensinniger Ansteuerung der beiden Wafer als Bieger fungieren können. Die Standardaktoren verfügen über ein bzw. zwei in einer Ebene hintereinander angeordnete Wafer, wobei für Sonderanwendungen auch bis zu fünflagige Module mit bis zu 2 x 5 Wafern je Ebene gefertigt wurden [Hopk98], [Mans99], [Ditt99] und [Dürr99]. Originär sind ACX QuickPacks® primär für die Applikation auf eine Struktur mittels eines Epoxidharzklebstoffes vorgesehen.

Die normalerweise mit Piezokeramikaktoren assoziierten negativen Eigenschaften wie Brüchigkeit, nicht unproblematische elektrische Kontaktierung sowie mangelnde elektrische Isolierung werden bei gekapselten, piezokeramischen Aktoren durch einen speziellen Herstellungsprozeß weitgehend eliminiert: Die elektrodierten piezoelektrischen Wafer sind in Dickenrichtung mit dünnen Polyimidfolien verklebt, auf die wiederum die elektrischen Leiterbahnen aus Kupfer aufgebracht sind, und somit kontaktiert und sowohl gegenseitig als auch gegenüber der Umgebung durch eine zusätzliche thermoplastische Umrandung (Spacer) elektrisch isoliert. Die Ladungsübertragung erfolgt ohne zusätzliche Hilfsstoffe oder Lötpunkte rein über den mechanischen Kontakt zwischen Kupferleiterbahn und Elektrodierung. An einem Ende des Aktors werden die einzelnen Polyimidfolien samt der aufgedruckten Leiterbahnen zu einer Art Flachbandkabel (Tail) zusammen geführt, das im Vergleich zu den Abmessungen des Aktors schmal und mit einem Standardstecker versehen ist. Neben einer zusätzlichen mechanischen Stabilisierung und leichten Druckvorspannung des gekapselten, piezokeramischen Aktors dient die Polyimidfolie als zusätzlicher Schutz gegenüber äußeren Einflüssen wie Feuchte oder Verschmutzung. Somit werden die spröden und dünnen Piezokeramikwafer relativ leicht handhab- und verarbeitbar [ACX]. Die als Beispiel für gekapselte, piezokeramische Aktoren erwähnten QuickPack® Aktoren sind in einer Reihe verschiedener Konfigurationen erhältlich. Die der hier beschriebenen Erfindung zu Grunde liegenden Untersuchungen wurden mit QP20N Aktoren durchgeführt und an QP40N Aktoren verifiziert.

Dieser Aktortyp ist seitens des Herstellers nur für Temperaturen bis max. 100°C zugelassen, bei höheren Temperaturen beginnen Teile der zur Kapselung und Verklebung der einzelnen Schichten verwendeten Kunststoffe sich zu zersetzen, was i.a. zu einer massiven Delamination des Aktors und einer damit einhergehenden katastrophalen Zerstörung führt. Moderne Hochleistungsverbundwerkstoffe werden jedoch im allgemeinen bei Temperaturen bis zu 180°C gefertigt, teilweise ist eine Temperung (Nachhärtung) der Bauteile bei noch höheren Temperaturen erforderlich.

Die beschriebenen Tails der QuickPack® Aktoren sind mit einer strukturkonformen Integration in Faserverbundwerkstoffe nicht vereinbar, da das Herausführen einer derartigen elektrischen Zuleitung aus einem Faserverbundbauteil das Durchtrennen der Decklagen auf dem Aktor erforderlich macht, was zwangsläufig mit einer nicht tolerierbaren Reduzierung der Festigkeit einhergeht und den Vorteil einer strukturellen Integration zunichte macht.

Aufgabe der Erfindung ist es, ein Faserverbundwerkstoff mit integriertem piezokeramischem Aktor oder Sensor zu schaffen, dessen elektrische Zuleitungen möglichst störungsfrei aus dem Faserverbund herausgeführt werden können, so dass die Integration des Aktors oder Sensors zu keinen signifikant verschlechterten mechanischen Eigenschaften führt. Eine weitere Aufgabe der Erfindung ist es, einen derartigen Faserverbundwerkstoff mit integriertem Aktor oder Sensor herzustellen, wobei insbesondere Struktur und Qualität der Oberfläche des Verbundwerkstoffs ohne Einschränkung erhalten bleiben sollen.

Diese Aufgaben werde mit dem Bauteil nach Patentanspruch 1 sowie dem Verfahren nach Patentanspruch 8 gelöst. Vorteilhafte Ausführungen sind Gegenstand von Unteransprüchen.

Der erfindungsgemäße Faserverbundwerkstoff mit darin integriertem piezokeramischem Sensor oder Aktor weist Zuleitungen für den Sensor oder Aktor in Form elektrisch isolierter, dünner Drähte auf, die senkrecht zu den Laminatlagen aus dem Faserverbundwerkstoffs herausgeführt sind. Dabei werden die Fasern durch das Herausführen der Zuleitungen nicht durchtrennt, sondern lediglich auseinandergeschoben. Somit wird die Integration des Aktors oder Sensors in die Faserverbundstruktur erreicht, ohne dass sich die Festigkeitseigenschaften des Bauteils signifikant verringern.

Innerhalb des Bauteils können die Zuleitung abschnittsweise auch parallel zu den Laminatlagen geführt werden. Dadurch ist es möglich, dass die Zuleitungen unabhängig vom Einbauort des Aktors an jedem beliebigen Ort auf der Oberfläche des Bauteils aus diesem austreten können.

Die Erfindung wird anhand von Ausführungsbeispielen unter Bezugnahme auf Zeichnungen näher erläutert. Es zeigen:
- Fig. 1: zwei piezokeramische Aktoren, die für die Erfindung besonders geeignet sind;
- Fig. 2: drei Ausführungen des erfindungsgemäßen Bauteils mit unterschiedlichen Konfigurationen der Integration des Aktors in das Faserverbundbauteil in schematischer Darstellung;
- Fig. 3: ein Autoklavaufbau für die Herstellung des erfindungsgemäßen Bauteils in einem Autoklaven;
- Fig. 4: ein Druckblech für die Herstellung des erfindungsgemäßen Bauteils in einem Autoklaven;
- Fig. 5: eine weitere Ausführung des erfindungsgemäßen Bauteils.

Fig. 1 zeigt zwei verschiedene piezokeramische Aktoren vom Typ QuickPack® der Firma ACX: QP20N (links) sowie QP40N (rechts). Der Aufbau dieser Aktoren wurde in der Beschreibungseinleitung erläutert. Aktoren dieser oder ähnlichen Bauart eignen sich im besonderen Maß für den erfindungsgemäßen Einsatz.

### Modifikation am Standard-Aktor

Wie bereits erwähnt, sind die Tails gekapselter, piezokeramischer Aktoren (z.B. QuickPack® Aktoren) mit einer strukturkonformen Integration in Faserverbundwerkstoffe nicht vereinbar, da das Herausführen einer derartigen elektrischen Zuleitung aus einem Faserverbundbauteil das Durchtrennen der Decklagen erforderlich macht, was zwangsläufig zu einer nicht tolerierbaren Reduzierung der Festigkeit führt. Deshalb wird das Tail nahe dem Aktor abgetrennt und die auf den Polyimidfolien aufgebrachten Kupferleiterbahnen z.B. mit einem feinen Diamantfräser angeschliffen. Der elektrische Anschluss erfolgt dann über dünne Kabel, die mit einem geeigneten Lot, das sich bei den Umgebungsbedingungen während der Fertigung nicht verflüssigen darf, an die Kupferleiterbahnen angelötet werden. Dabei ist darauf zu achten, dass der Lötpunkt nicht aufdickt und der gesamte Anschlussbereich die Dicke des Aktors nicht überschreitet. Bei der Auswahl der Kabel (z.B. Kupfer Isolierdraht Ø 0,2 mm oder Ø 0,5 mm) ist darauf zu achten, dass sie einerseits ausreichend elektrisch isoliert sind und andererseits den Umgebungsbedingungen während der Fertigung unbeschadet und voll funktionsfähig standhalten. Ebenso muss der Leitungsquerschnitt entsprechend des späteren Betriebsbereiches des Aktors derart gewählt werden, dass keine Erwärmung der elektrischen Zuleitung und somit eine Störung oder gar Schädigung der Struktur auftreten kann. Ein weiterer Vorteil der Modifikation der elektrischen Zuleitung wie beschrieben liegt in einer deutlich vereinfachten Handhabung der Zuleitungen im Rahmen des weiteren Fertigungsprozesses, da beispielsweise deren Länge beliebig eingestellt werden kann.

Die elektrische Isolierung der Lötstellen kann entweder mit einem Epoxidharz, einem Isolierlack oder einem isolierenden Polyimidklebeband erfolgen, wobei das verwendete Produkt wiederum den Umgebungsbedingungen während der Fertigung voll funktionsfähig standhalten muss. Vollkommen elektrische Isolierung ist insbesondere bei der Integration in CFK-Strukturen zwingend erforderlich - eine häufige Fehlerquelle stellt die Schnittkante am Tail dar.

### Integrationsverfahren

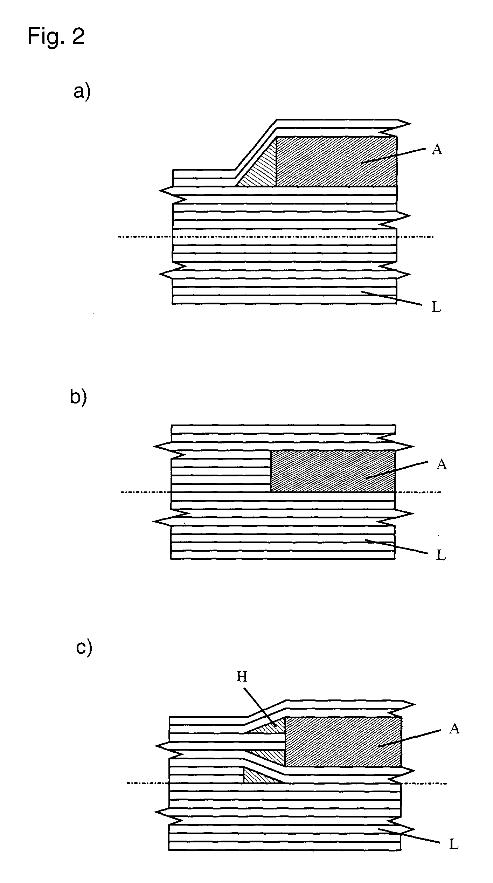

Bei der strukturellen Integration der Aktoren in den Faserverbundwerkstoff sind generell eine Vielzahl unterschiedlicher Konfigurationen denkbar. Drei konkrete Konfigurationen sind in Fig. 2 exemplarisch dargestellt. Bei allen drei gezeigten Ausführungen ist der Aktor A innerhalb des Faserverbundbauteils integriert, d.h. der Aktor ist auf beiden Seiten von mindestens einer Lage des Laminats L bedeckt. In der Ausführung nach Fig. 2a) werden für die Integration des Aktors keine Laminatlagen durchtrennt. Der Aktor A wird zwischen zwei benachbarten Lagen des Laminats L platziert. In der Ausführung nach Fig. 2b sind in mehreren Laminatlagen Aussparungen für den Aktor A vorgesehen. Die in Fig. 2c dargestellte Ausführung ist eine Mischform der beiden vorher beschriebenen Ausführungen gemäß Fig. 2a und 2b. Es werden einzelne Lagen mit Aussparungen versehen, deren Gesamtdicke jedoch kleiner als die Höhe des Aktors A ist. An die mit Aussparungen versehenen Lagen schließen sich normale Lagen ohne Aussparungen an. Die entstehenden Taschen H füllen sich während der Härtung des Bauteils mit Harz.

Die Fertigung der erfindungsgemäßen Faserverbundstruktur mittels Prepreg- oder Nasslaminierverfahren erfolgt bis zu den Lagen, in bzw. auf die die Aktoren integriert werden sollen, in den üblichen Schritten. Es wurden Probekörper gemäß Fig. 2 aus CFK-Pregregmaterial (T800/5245C, BASF Narmco) hergestellt und getestet. Im Bereich des Aktors durchtrennte Lagen werden zunächst aufeinander laminiert, dann wird mit Hilfe von Schablonen unter Berücksichtigung des Tail-Stumpfes der Ausschnitt für den Aktor in diese Teillaminate eingebracht. Diese Teillaminate werden dann in der üblichen Weise auf das schon bestehende, von der Integration des Aktors nicht betroffene Laminat auflaminiert und unter Vakuum verdichtet. Zuletzt wird der Aktor in die Aussparung eingesetzt und ebenfalls unter Vakuum mit dem Laminat verpresst. In die Decklagen (≡ Lagen über dem Aktor), auf die einseitig bereits das Abreißgewebe aufgebracht ist, werden mittels einer Schablone die Durchstoßpunkte für die elektrischen Zuleitungen markiert und mit einer feinen Nadel eingebracht. Durch dieses Vorgehen ist sicher gestellt, dass die Verstärkungsfasern der Struktur lediglich auseinander geschoben, nicht jedoch durchtrennt werden, was sich letztlich maßgeblich auf die Festigkeit des Bauteils auswirkt. Anschließend werden die elektrischen Zuleitungen durch das Decklaminat hindurch geführt und gestrafft, das Laminat dann mit dem restlichen Bauteil verpresst. Grundsätzlich können auch mehrere Drähte durch eine gemeinsame Öffnung geführt werden. Bei sämtlichen Arbeitsschritten, insbesondere dem Konsolidieren unter Vakuum ist ein Knicken der Kabel zu vermeiden.

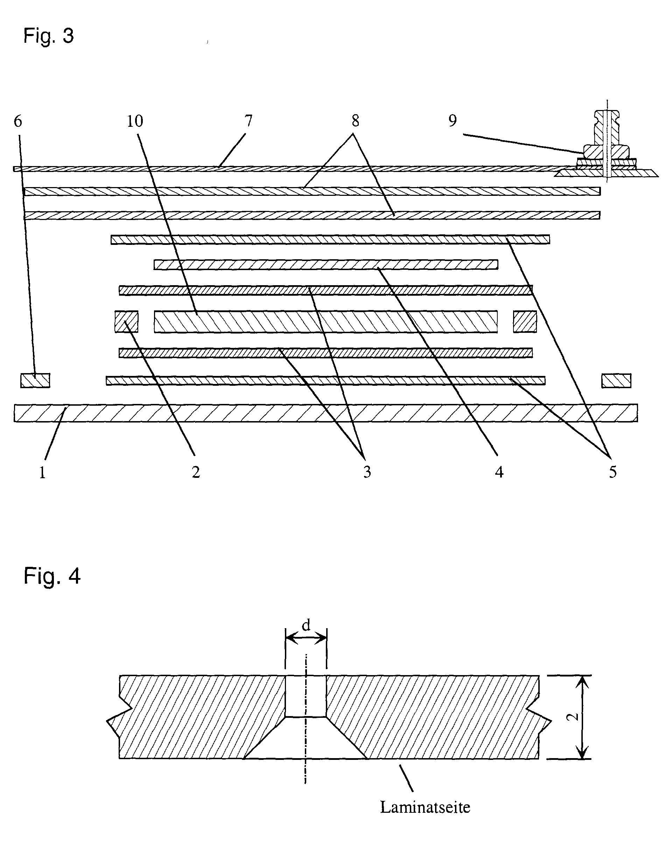

Für die Härtung des Faserverbundbauteils im Autoklav wird ein Standardaufbau gemäß Fig. 3 verwendet. Die Bezugsziffern bedeuten:
1 Grundplatte
2 Randleiste
3 Teflon-Abreißgewebe
4 Druckblech
5 Trennfolie
6 Dichtband
7 Vakuumfolie
8 Vlies
9 Vakuumstutzen
10 Faserverbundwerkstoff

Anstelle eines massiven Druckstücks (üblicherweise polierte Aluminiumplatte mit t ≥ 12 mm) wird ein dünnes Druckblech 4, wie in Fig. 4 separat dargestellt, verwendet. Durch die hierdurch verringerte Steifigkeit wird der im allgemeinen durch den integrierten oder applizierten Aktor gegebenen geringfügigen Aufdickung in diesem Bereich dahingehend Rechnung getragen, dass das Auspressen der Matrix im entsprechenden Schnitt bei Druckbeaufschlagung im Autoklav reduziert und folglich die mechanischen Eigenschaften des Faserverbundwerkstoffs nur geringfügig beeinflusst werden.

Als Druckblech haben sich Aluminiumbleche einer Stärke von 2 mm bewährt. An den Stellen, an denen die elektrischen Zuleitungen aus dem Bauteil austreten - diese Punkte können bei dem beschriebenen Verfahren an jedem beliebigen Ort auf der Oberfläche des Faserverbundbauteils liegen - werden Bohrungen mit einem Durchmesser d, der bei der verwendeten Dicke des Druckbleches etwa 1 mm über dem Durchmesser des verwendeten elektrischen Leiters liegen sollte, in die Bleche eingebracht. Diese Bohrungen werden von der Laminatseite her gut 1 mm tief angesenkt und entgratet. Abschließend wird das Druckblech mit den üblichen Trennmitteln behandelt. Anstatt der genannten Bohrungen können Durchbrechungen beliebigen Querschnitts in dem Druckblech vorhanden sein, welche laminatseitig angefast werden.

Das Druckblech kann im Bereich des integrierten gekapselten piezokeramischen Aktors oder Sensors laminatseitig eine Aussparung geringer Tiefe (z.B. 0,1-0,2 mm) aufweisen, um ein Auspressen von Matrix aufgrund der Aufdickung in diesem Bereich zu verhindern.

Bei der Vorbereitung des Autoklavaufbaus sollte darauf geachtet werden, dass die Drähte straff durch die Druckbleche geführt und während der Arbeiten nicht von dem Druckblech beschädigt oder gar abgeschert werden. Sobald Druckblech 4 und Randleisten 2 fixiert sind, werden die Bohrungen, aus denen die Drähte durch das Druckblech hindurchgeführt sind, beidseitig mit mehreren Streifen Dichtband 6 abgedichtet und die Drähte nachfolgend locker auf dem Blech fixiert.

Bei der Härtung des Bauteils liegen die Druck- und Temperaturwerte insbesondere innerhalb folgender Bereiche:
Druck: 3 - 10 bar,
Temperatur: 120 - 220 °C.

Das beschriebene Vorgehen bzw. dieser Aufbau zeichnet sich durch folgende Vorteile aus:
- Dadurch, dass die Drähte senkrecht zur Fläche aus dem Laminat herausgeführt werden - dies ist an jedem beliebigen Ort möglich, da die Drähte ohne signifikante Störung der Laminateigenschaften in der Ebene weitergeführt werden können - wird der i.a. erforderliche Randbeschnitt der Bauteile möglich. Dies war bei den bislang in der Literatur vorgestellten Lösungen in dieser einfachen Form nicht der Fall.
- Die Verwendung von Druckblechen anstelle massiver Druckstücke erhält die Eigenschaften der Faserverbundstruktur weitgehend, wobei in den Bereichen der integrierten Aktoren ggf. sanftere geometrische Übergänge im Bauteil entstehen und mechanische Spannungsspitzen deutlich reduziert werden.
- Durch das Durchführen der elektrischen Zuleitungen durch das Druckblech an genau den Punkten, an denen sie aus dem Laminat austreten, bleibt die einwandfreie Oberflächenqualität des Bauteils vollkommen erhalten.
- Das Ansenken der Bohrungen im Druckblech verringert die Gefahr einer Beschädigung bzw. des Abscheren der elektrischen Zuleitungen signifikant und führt zudem zu höheren zulässigen Toleranzen bei der Fertigung.
- Durch das Dichtband an den Austrittspunkten sind die elektrischen Zuleitungen auf dem Blech gegen (Ab-) Knicken geschützt.
- Da die Druckbeaufschlagung im Autoklav (i.a. 7 bar außerhalb des Autoklavaufbaus) vor Verflüssigung der Matrix durch den Temperaturanstieg (i.a. 180°C) erfolgt, wird ein Teil des um die Bohrungen aufgebrachten Dichtbands durch die Spalte zwischen Draht und Druckblech hindurchgepresst und füllt den durch das Ansenken des Bleches entstandenen Kegelstumpf komplett aus (dadurch, dass das Bauteil innerhalb des Autoklavaufbaus gleichzeitig mit Vakuum beaufschlagt wird, entstehen hierbei keinerlei Lufteinschlüsse). Dies resultiert in folgenden Vorteilen:

- Hervorragende Abdichtung der Bohrungen, kein Harzausfluss mit den entsprechend negativen Folgen auf die mechanischen Eigenschaften des Bauteils.
- Absolut ebene Oberfläche an den Punkten des Drahtaustritts aus dem Laminat durch isostatische Druckverteilung bereits vor Verflüssigung der Matrix.
- Aufgrund des im Spalt zwischen Druckblech und Draht verpressten Dichtbandes ist kein Verkleben von Druckblech und Draht durch ausgetretene Matrix möglich.
- Durch den geringen Spalt zwischen Druckblech und Draht bleibt die zum Abheben der Druckbleche nach der Härtung des Bauteils zu überwindende Zugbzw. Schubkraft und somit die Gefahr eines Abreißens der Drähte gering. Die Druckbleche lassen sich leicht vom Bauteil lösen.

Das oben beschriebene erfindungsgemäße Fertigungsverfahren wurde anhand des Autoklavverfahrens exemplarisch beschrieben. Eine Adaption auf andere Fertigungsverfahren für Faserverbundwerkstoffe, beispielsweise auf das RTM-Verfahren (Resin Transfer Moulding) oder auf daraus abgeleitete Verfahren, ist leicht möglich. Wesentliche Einschränkungen, insbesondere was die Modifikation des Vakuumaufbaus betrifft, ergeben sich dabei nicht.

Eingehende Untersuchungen haben ergeben, dass die katastrophale Zerstörung der QuickPack® -Aktoren bei der oben beschriebenen Verarbeitung gemäß Stand der Technik höchstwahrscheinlich auf der Sublimation der internen Klebeschichten und teilweise auch der thermoplastischen Spacer bei Temperaturen oberhalb von etwa 100°C beruht, die großflächige Delaminationen im Aktor zur Folge haben. Eine derartige Zerstörung gekapselter piezokeramischer Aktoren kann durch eine gleichzeitig mit der Temperaturlast aufgebrachte Druckbeaufschlagung verhindert werden.

Da der Härtezyklus einiger Matrixsysteme einen Temperprozess (Nachhärten zum vollständigen Vernetzen der Matrix) beinhaltet, der primär aus Kostengründen i.a. nicht im Autoklav durchgeführt wird, kann dieser bei Faserverbundstrukturen mit nach dem oben beschriebenen Verfahren eingebetteten QuickPacks® folglich nur unter Druckbeaufschlagung durchgeführt werden. Für das hier verwendete CFK-System (T800/5245C) ist ein Temperprozess von 4 h @ 210°C vorgesehen. Um die Aktoren nicht über das im Autoklav vorhandene Temperaturniveau hinaus zu belasten, wurde die Temperatur des Temperprozesses auf diese Temperatur (180°C) abgesenkt, wobei die Dauer zur vollständigen Nachvernetzung gleichzeitig deutlich erhöht werden mußte. Anhand der ILS-Werte (Interlaminare Scherfestigkeit, vgl. EN 2563) einer Reihe von Proben ergab sich der modifizierte Temperzyklus für das hier verwendete CFK-System zu 16h @ 180°C, wobei ein Druck von 7 - 10 bar in einer Warmpresse beaufschlagt wurde. Hierbei sind durchaus auch andere Formen der (mechanischen) Druckbeaufschlagung denkbar, die keinen großen maschinellen Aufwand erfordern. Um eine gleichförmige Druckverteilung auf die Aktoren sicher zu stellen, hat sich eine durch mehrere Lagen dichtes Teflongewebe vom direkten Kontakt mit dem Bauteil abgehaltene Schicht Gummi von einer Dicke zwischen 15-20 mm bewährt. Die Gefahr einer mechanischen Depolarisation der Aktoren oder eines Querdruckversagens des Faserverbundes besteht bei diesen Drücken nicht.

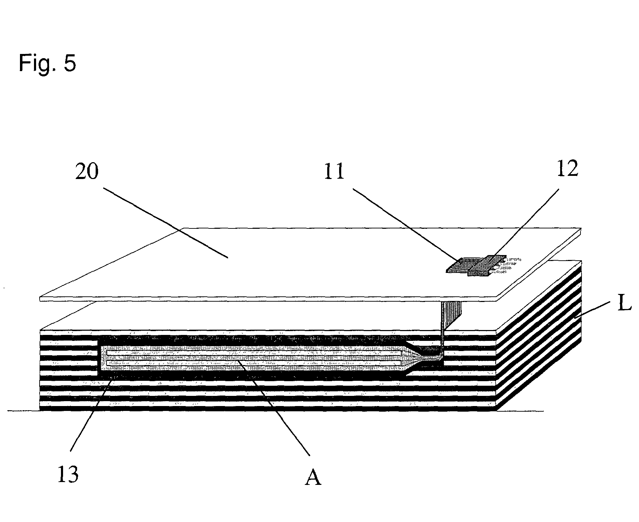

Fig. 5 zeigt den schematischen Aufbau eines fertigen Bauteils gemäß der Erfindung. Man erkennt den von einer Isolierfolie 13 umgebenen Aktor A, der innerhalb der einzelnen Lagen des Laminats L angeordnet ist. Zur Integration des Aktors A sind in mehreren Laminatlagen Aussparungen vorgesehen. Die Konfiguration der Integration des Aktors A entspricht somit der in Fig. 2b gezeigten. Die elektrischen Zuleitungen 11 werden erfindungsgemäß senkrecht durch die Decklagen 20 hindurch, also senkrecht zur Bauteilebene, aus dem Bauteil herausgeführt. Optional kann außerhalb des Bauteils ein Steckanschluss 12 für die Kontaktierung der Zuleitungen 11 vorhanden sein.

Die vorstehend beschriebenen Ausführungen der Erfindung wurden anhand der Integration von QuickPack® -Aktoren erläutert. Die Erfindung ist jedoch nicht auf diesen Aktortyp beschränkt, sondern kann insbesondere hinsichtlich Führung und elektrischer Isolierung der Zuleitungen sowie Vakuumaufbau für die Härtung im Autoklav und dem Vorgehen beim Tempern auch auf andere Aktoren übertragen werden, beispielsweise auf die von der Continuum Control Corporation [CCC] entwickelten Active Fiber Composites (AFCs) / SmartPly® gemäß US 5 869 189 aus piezokeramischen Fasern. Ebenso ist die beschriebene Vorgehensweise nicht auf Kohlenstoffaser verstärkte Kunststoffe oder Duroplaste beschränkt, sondern kann beispielsweise auch für thermoplastische GFK-Systeme angewendet werden.

**Literatur zum Stand der Technik:**
- [ACX]: www.acx.com
- [CCC]: http://www.continuumcontrol.com
- [Ditt99]: Dittrich, K.; Simpson, J.; Becker, J.; Dürr, J. K.; Floeth, E.; Ihler, E.; Herold-Schmidt, U.; Zaglauer, H. W.: *Fin-Buffet Alleviation via Distributed Piezoelectric Actuators - Materials Qualification Program,* Proc. SPIE Vol. 3674: 22-30, 1999.
- [Dürr99]: Dürr, J. K.; Krohn, H.; Nixdorf, K.; Lütze, S.; Herold-Schmidt, U.; Busse, *G.: Non-Destructive Testing of Surface Bonded Piezoelectric Patch Actuators,* Proc. SPIE Vol. 3674: 39-50, 1999.
- [Hopk98]: Hopkins, M. A.; Henderson, D. A., Moses, R. W.; Ryall, T.; Zimcik, D. G.; Spangler, R. L.: *Active vibration-suppression systems applied to twin-tail buffeting*, Proc. SPIE Vol. 3326: 27-33, 1998.
- [Mans99]: Manser, R.; Simpson, J.; Becker, J.; Dürr, J. K.; Floeth, E.; Herold-Schmidt, U.; Stark, H.; Zaglauer, H. W.: *Fin-Buffet Alleviation via Distributed Piezoelectric Actuators - Full-Scale Demonstrator Tests,* Proc. SPIE Vol. 3674: 13-21, 1999,

## Patentansprüche

1. Faserverbundwerkstoff (10) mit darin integriertem piezoelektrischem Aktor (A) oder Sensor, **dadurch gekennzeichnet, dass** die elektrischen Zuleitungen (11) für den Aktor (A) oder Sensor in Form elektrisch isolierter, dünner Drähte vorliegen, die senkrecht zu den Laminatlagen aus dem Faserverbundwerkstoff (10) herausgeführt sind, wobei die Fasern durch das Herausführen der Zuleitungen (11) nicht durchtrennt, sondern auseinandergeschoben werden.

2. Faserverbundwerkstoff nach Patentanspruch 1, **dadurch gekennzeichnet, dass** die Zuleitungen (11) einen Durchmesser von kleiner als 1 mm, insbesondere kleiner als 0,5 mm aufweisen.

3. Faserverbundwerkstoff nach einem der Patentansprüche 1 oder 2, **dadurch gekennzeichnet, dass** die Zuleitungen (11) innerhalb des Faserverbundwerkstoffs (10) abschnittsweise parallel zu den Laminatlagen geführt werden.

4. Faserverbundwerkstoff nach einem der vorangehenden Ansprüche, **dadurch gekennzeichnet, dass** die Drähte an dem Aktor (A) oder Sensor mittels eines Leitklebstoffs oder Lots befestigt sind.

5. Faserverbundwerkstoff nach einem der vorangehenden Ansprüche, **dadurch gekennzeichnet, dass** die Isolierung der Kontaktpunkte zwischen Aktor (A) oder Sensor und elektrischer Zuleitung mittels eines Epoxidharzes, eines Isolierlacks oder einer isolierenden Polyimidfolie erfolgt.

6. Faserverbundwerkstoff nach einem der vorangehenden Ansprüche, **dadurch gekennzeichnet, dass** für den Aktor (A) oder Sensor Aussparungen in den Laminatlagen vorgesehen sind.

7. Faserverbundwerkstoff nach einem der vorangehenden Ansprüche 1 bis 5, **dadurch gekennzeichnet, dass** der Aktor (A) oder Sensor zwischen zwei aufeinanderfolgenden Laminatlagen ohne Aussparungen integriert ist.

8. Verfahren zur Herstellung eines Faserverbundwerkstoffs (10) mit darin integriertem Aktor (A) oder Sensor, nach einem der vorangehenden Ansprüche, mittels Prepreg- oder Nasslaminiertechnik und anschließender Härtung unter erhöhter Temperatur und erhöhtem Druck.

9. Verfahren zur Herstellung eines Faserverbundwerkstoffs (10) mit darin integriertem Aktor (A) oder Sensor nach einem der Ansprüche 1 bis 7, mittels Prepreg- oder Nasslaminiertechnik und nachfolgender Härtung unter erhöhter Temperatur sowie nachfolgendem Tempern unter erhöhter Temperatur und erhöhtem Druck.

10. Verfahren nach Anspruch 8 oder 9, **dadurch gekennzeichnet, dass** in den Druckstücken (4) für die Druckbehandlung des Faserverbundwerkstoffs (10) Durchbrechungen vorhanden sind, die zur Durchführung der Zuleitungen (11) für den Aktor (A) oder Sensor dienen, und die Durchbrechungen an den Stellen angeordnet sind, an denen die Zuleitungen für den Aktor (A) oder Sensor aus dem Faserverbundwerkstoff (10) austreten.

11. Verfahren nach Anspruch 10, **dadurch gekennzeichnet, dass** die Durchbrechungen in den Druckstücken (4) laminatseitig angesenkt bzw. angefast sind.

12. Verfahren nach einem der Ansprüche 10 oder 11, **dadurch gekennzeichnet, dass** die Durchbrechungen mit einem Dichtband (6) abgedichtet sind, wobei ein Teil des Dichtbands (6) aufgrund des während des Härtezyklus vorhandenen Druckunterschieds in den Spalt zwischen Zuleitung (11) und Druckstück (4) gepresst wird.

13. Verfahren nach einem der Ansprüche 10 bis 12, **dadurch gekennzeichnet, dass** Druckstücke (4) eingesetzt werden, die gegenüber den bekannten, massiven Druckstücken eine reduzierte Steifigkeit aufweisen, insbesondere solche, die Stärke von weniger als 5 mm, z.B. 2 mm, aufweisen.

14. Verfahren nach einem der Ansprüche 10 bis 13, **dadurch gekennzeichnet, dass** das Druckstück (4) im Bereich des Aktors oder Sensors laminatseitig eine Aussparung geringer Tiefe (z.B. 0,1-0,2 mm) aufweist, um ein Auspressen von Matrix aufgrund der Aufdickung in diesem Bereich zu verhindern.
